**Europäisches Patentamt**

**European Patent Office**

**Office européen des brevets**

(19)

(11) Veröffentlichungsnummer : **0 489 337 B1**

(12)
# EUROPÄISCHE PATENTSCHRIFT

(45) Veröffentlichungstag der Patentschrift :
**22.06.94 Patentblatt 94/25**

(51) Int. Cl.[5] : **C23C 16/00,** C23C 16/14,
C23C 16/08

(21) Anmeldenummer : **91120163.0**

(22) Anmeldetag : **26.11.91**

(54) **Verfahren zur selektiven Abscheidung von Wolfram auf einer Siliziumoberfläche.**

(30) Priorität : **06.12.90 DE 4038990**

(43) Veröffentlichungstag der Anmeldung :
**10.06.92 Patentblatt 92/24**

(45) Bekanntmachung des Hinweises auf die
Patenterteilung :
**22.06.94 Patentblatt 94/25**

(84) Benannte Vertragsstaaten :
**CH DE FR LI**

(56) Entgegenhaltungen :
**TUNGSTEN AND OTHER ADVANCED METALS
FOR VLSI/ULSI APPLICATIONS, V. Bd. 5,
19.Oktober 1989, PITTSBURGH, PENSYLVA-
NIA, USA Seiten 109 - 116; C.R.KLEIJN ET AL.:
'An experimental and modeling study of the
tungsten LPCVD growth kineticsfrom H2-WF6
at low WF6 partial pressures.'
APPLIED SURFACE SCIENCE Bd. 38, 10. April
1989, AMSTERDAM NL Seiten 370 - 385;J.I.
ULACIA ET AL.: 'Flow and reaction simulation
of a tungsten cvd reactor'**

(73) Patentinhaber : **SIEMENS
AKTIENGESELLSCHAFT
Wittelsbacherplatz 2
D-80333 München (DE)**

(72) Erfinder : **Werner, Christoph, Dr.
Pentenriederstrasse 15a
W-8033 Krailling (DE)**
Erfinder : **Ulacia, Ignacio, Dr.
c/o Qualtec Co. POB 5-650
Guadalajara, Jalisco 45042 (MX)**

## Beschreibung

Die selektive Abscheidung von Wolfram auf Silizium findet in der Technologie integrierter Schaltungen zum Beispiel zum Auffüllen von Kontaktlöchern Anwendung. Dabei wird Wolfram gezielt auf freigeätzten Siliziumflächen abgeschieden. Die Siliziumfläche umgebende Strukturen aus Siliziumoxid sollen bei der Abscheidung freibleiben.

Bei der selektiven Abscheidung von Wolfram tritt das Problem auf, daß neben der gewünschten Wolframabscheidung auf der Siliziumoberfläche auch einige unerwünschte Wolfram-Keime auf den maskierenden Strukturen aus Siliziumoxid aufwachsen. Der Grund dafür ist die Erzeugung von intermediären Reaktionsprodukten, die in kleiner Konzentration bei der Wolframabscheidung auf Silizium entstehen. Aufgrund ihrer höheren Reaktivität führen diese intermediären Reaktionsprodukte auch auf $SiO_2$ und nicht nur auf der Siliziumoberfläche zur Abscheidung von Wolfram.

Aus C. M. Mc Conica et al, Journ. of the Electrochemical Society 133, Seiten 2542 bis 2548 (1986) ist bekannt, die Abscheidung von Wolfram-Keimen auf $SiO_2$-Flächen dadurch zu umgehen, daß die Temperatur oder der Druck während der Abscheidung reduziert werden. Dadurch wird die Produktionsrate der unerwünschten Reaktionsprodukte und damit die Anzahl der Wolfram-Keime auf den maskierenden Strukturen aus $SiO_2$ verringert. Gleichzeitig wird jedoch auch die Abscheiderate von Wolfram auf der Siliziumoberfläche reduziert. Daher müssen wesentlich längere Prozeßzeiten in Kauf genommen werden.

Die Prozeßparameter Druck, Temperatur sowie Durchflußraten der Prozeßgase hängen darüber hinaus von der speziellen Geometrie des Reaktors, in dem die Abscheidung aus der Gasphase vorgenommen wird, ab. Diese Prozeßparameter müssen durch langwierige Versuchsreihen so optimiert werden, daß die Selektivität der Wolframabscheidung ausreichend gut ist und daß gleichzeitig die Wolframabscheiderate auf der Siliziumoberfläche nicht zu gering ist.

Aus S. S. Wong, S. Furukawa: "Tungsten and Other Advanced Metals for VLSI/ULSI Applications V", Bd. 5 (19.10.1989), Materials Research Society, Pittsburgh (Pennsylvania/USA), Seiten 109 bis 116 (Artikel von C. R. Kleijn et al), ist eine Untersuchung der Wolfram-Schichtwachstumskinetik bekannt. Dabei wird der Einfluß der Prozeßparameter Temperatur, Druck und Durchflußraten auf die Abscheiderate mit Hilfe eines mathematischen Modells berechnet und mit Messungen verglichen. Das mathematische Modell berücksichtigt die Erhaltungssätze für Masse, Impuls und Energie unter den Randbedingungen der Apparatur. Es gehen Koeffizienten der binären Diffusion für Thermodiffusion ein. Reaktionen in der Gasphase werden jedoch vernachlässigt. Bei der Vorhersage der Diffusionskoeffizienten treten in dem bekannten Modell Fehler von 50 Prozent auf.

Der Erfindung liegt die Aufgabe zugrunde, ein weiteres Verfahren zur selektiven Abscheidung von Wolfram auf einer Siliziumoberfläche anzugeben, bei dem eine zeit- und kostensparende Optimierung der Prozeßparameter eingesetzt wird.

Diese Aufgabe wird erfindungsgemäß gelöst durch ein Verfahren nach Anspruch 1.

Das im Anspruch 1 angegebene Gleichungssystem wird insbesondere numerisch am Rechner gelöst. Dadurch tritt an die Stelle der Versuchsreihen ein Simulationsprogramm. Damit ist eine schnellere und kostengünstigere Optimierung der Abscheiderate möglich als durch lange Versuchsreihen.

Es ist besonders vorteilhaft, bei der Lösung des Gleichungssystems ein Koordinatensystem zugrundezulegen, das an die Symmetrie des CVD-Reaktors angepaßt ist. Dadurch kann der Einfluß von geometrischen Veränderungen des CVD-Reaktors auf die Prozeßparameter schnell ermittelt werden.

Die Erfindung ist insbesondere anwendbar, wenn die maskierende Struktur aus $SiO_2$ besteht. Es liegt jedoch ebenfalls im Rahmen der Erfindung, daß die maskierende Struktur aus anderen Materialien, zum Beispiel $Si_3N_4$ besteht.

Als Prozeßgase werden zum Beispiel $H_2$ und $WF_6$ zugeführt. In dem CVD-Reaktor werden durch chemische Reaktionen HF, $WF_x$ und $SiF_x$ erzeugt. Die Erfindung ist ebenfalls anwendbar, wenn zusätzlich zu den genannten Prozeßgasen $SiH_4$ zugeführt wird.

Die Reaktionsprodukte $WF_x$ und $SiF_x$ fördern die Keimbildung auf der maskierenden Struktur und führen daher zu einer Abnahme der Selektivität der Abscheidung.

Weitere Ausgestaltungen der Erfindung gehen aus den übrigen Ansprüchen hervor.

Eine Untersuchung über den Gasfluß und die Reaktionen in einem Wolfram-CVD-Reaktor ist aus I. Ulacia et al, Appl. Surface Science, 38, Seiten 370 bis 385 (1989) bekannt. Dabei wurde jedoch der Effekt der Thermodiffusion und der Multikomponentendiffusion vernachlässigt. Dieser Effekt ist jedoch für die selektive Abscheidung von Wolfram auf einer Siliziumoberfläche von entscheidender Bedeutung.

Die Wolframabscheidung findet zum Beispiel in einem zylinderförmigen CVD-Reaktor statt. Am Boden des CVD-Reaktors wird das Gemisch der Prozeßgase in den CVD-Reaktor eingelassen. Die Siliziumoberfläche ist senkrecht zur Gaseinlaßrichtung angeordnet. An der dem Boden gegenüber angeordneten Deckfläche des CVD-Reaktors wird das Gas über mehrere, zum Beispiel vier, Pumpstutzen abgesaugt. Die Oberfläche des CVD-Reaktors wird zum Beispiel mit Wasser gekühlt. Die Siliziumoberfläche wird von ihrer Rückseite her zum Beispiel durch Bestrahlung mit Halogenlampen geheizt. Wegen der Symmetrie des CVD-Reaktors ist es zweckmäßig, das Gleichungssystem in zylindrischen Polarkoordinaten zu lösen.

Es hat sich gezeigt, daß sich in einem solchen CVD-Reaktor ein einheitlicher Fluß parallel zur Siliziumoberfläche ausbildet. Daher ist es für viele Anwendungen ausreichend, das Gleichungssystem nur in einer Ebene senkrecht zu der Siliziumoberfläche zu lösen. Dadurch wird im Vergleich zur Lösung in dem dreidimensionalen CVD-Reaktor erheblich Rechenzeit eingespart.

Das zu lösende Gleichungssystem beinhaltet alle wesentlichen physikalischen Vorgänge in Form von partiellen Differentialgleichungen. Dabei wird insbesondere der Transport von Komponenten mit niedriger Konzentration in dem Gemisch der Prozeßgase bei starken Temperaturgradienten berücksichtigt. Die Diffusion der Prozeßgase in dem Reaktor wird zum Beispiel durch folgende Gleichung beschrieben:

$$\frac{\partial \rho m_i}{\partial t} = \text{div} \left( \rho m_i \cdot \vec{v} - \rho \sum_j D_{ij} \nabla m_j - D_i^T \nabla (\ln T) \right) + G_i$$

Dabei bedeutet $\rho$ die Dichte im Medium, $m_i$ der Massenbruchteil eines Teilchens i, t die Zeit, $\vec{v}$ die Geschwindigkeit, $D_{ij}$ den Koeffizienten für Multikomponentendiffusion, $D_i^T$ den Koeffizienten für Thermodiffusion, T die Temperatur und $G_i$ die Generationsrate des Teilchens i.

Die Produktion von unerwünschten Reaktionsprodukten wie $WF_x$ und $SiF_x$, deren Adsorption an der maskierenden Struktur aus $SiO_2$ und deren Nukleationsrate als Funktion der lokalen Konzentration wird durch folgende Gleichungen beschrieben:

Bildung und Adsorption von $WF_x$

$$j_{WF_x} = k_1 \theta [WF_6] - k_2 [WF_x]$$

Dabei bedeutet $j_{WF_x}$ den Fluß von $WF_x$, $k_1 = 10^{-5}$ kg/(ms), $\theta$ den Anteil der Fläche der mit Wolfram bedeckt ist, $k_2 = 10^{-3}$kg/(ms). $[WF_6]$ bzw. $[WF_x]$ sind die Massenbruchteile der Teilchen $WF_6$ bzw. $WF_x$.

Die Nukleationsrate wird beschrieben durch

$$n = (1 - \theta) k_3 [WF_x]$$

Dabei bedeutet n die Nukleationsrate pro Flächeneinheit, $\theta$ der Anteil der Fläche, der mit Wolfram bedeckt ist, und $k_3 = 10^{13}$ s$^{-1}$ m$^{-2}$.

Die zeitliche Änderung des Anteils $\theta$ der Fläche, die mit Wolfram bedeckt ist, wird durch folgende Gleichung beschrieben:

$$\frac{d\theta}{dt} = (1 - \theta) \, 2\pi \, R_w \int_0^t n(t') (t - t') R_w dt'$$

Dabei bedeutet $\theta$ den Anteil der Fläche, der mit Wolfram bedeckt ist, $R_w$ die Abscheiderate von Wolfram, t die Zeit, n die Nukleationsrate pro Flächeneinheit.

Das Schichtwachstum auf der Siliziumoberfläche ist abhängig von dem Transport der chemischen Komponenten zu den reagierenden Flächen und von der Geschwindigkeit der chemischen Reaktion selbst. Die Abscheidung erfolgt durch thermische Reduktion von Wolframhexafluorid und Wasserstoff entsprechend der Reaktionsgleichung:

$$WF_6 (g) + 3 H_2 (g) \rightarrow W (s) + 6 HF (g).$$

Die Abscheiderate $R_w$ von Wolfram beträgt:

$$R_w = \left\{ \left( \frac{1}{\rho_w} D_{WF_6} \frac{N'_{WF_6}}{\delta} \right)^{-1} + \left( k_0 \exp\frac{-E_a}{kT} \cdot P_{H_2}^{1/2} \right)^{-1} \right\}^{-1}$$

wobei $\rho_W$ die Dichte des CVD-Wolframs ist, $D_{WF6}$ der Diffusionskoeffizient von $WF_6$ in $H_2$ bei den Betriebsbedingungen, $N'_{WF6}$ die Konzentration von $WF_6$ am betrachteten Ort, $\delta$ der Abstand des Ortes von der Siliziumoberfläche, $P_{H2}$ der Druck des $H_2$, $k_0 = 4.08 \times 10^6$ (nm min$^{-1}$ Pa$^{-1/2}$), Ea = 0,75 eV die Aktierungsenergie.

Die Rechnung wird iterativ durchgeführt. Dabei werden die Werte für den Druck am Gasauslaß z. B. zwischen 10 Pa und 150 Pa, die Temperatur an einem die Siliziumoberfläche enthaltenden Substrat zwischen 300 °C und 450 °C und die Durchflußrate für $WF_6$ zwischen 10 sccm/min und 50 sccm/min variiert. Dabei wird für die Durchflußraten für $H_2$ 1000 sccm/min angenommen. Der Parametersatz, bei dem die Abscheiderate des Wolfram bei vorgegebener Selektivität einen vorgegebenen Wert erreicht, wird für die Abscheidung verwendet.

## Patentansprüche

1. Verfahren zur selektiven Abscheidung von Wolfram auf einer Siliziumoberfläche mit folgenden Schritten:
a) die Siliziumoberfläche wird mit einer maskierenden Struktur versehen,
b) in einem CVD-Reaktor wird die Abscheidung aus der Gasphase aus einem Gemisch von Prozeßgasen, das $H_2$ und $WF_6$ enthält, so durchgeführt, daß die maskierende Struktur im wesentlichen frei von Wolfram bleibt,
c) die Prozeßparameter Temperatur, Druck und Durchflußraten der Prozeßgase für die selektive Abscheidung werden für eine vorgegebene Abscheiderate durch Lösung folgender Gleichungen bestimmt:

$$\frac{\partial \rho m_i}{\partial t} = \text{div}\left( pm_i \bar{v} - \rho \sum_j D_{ij} Vm_j - D_i^T \nabla(\ln T) \right) + G_i$$

$$j_{WF_x} = k_1 \theta [WF_6] - k_2 [WF_x]$$
$$n = (1 - \theta) k_3 [WF_x]$$

$$\frac{d\theta}{dt} = (1 - \theta) 2\pi R_W \int_o^t n(t')(t - t') R_W dt'$$

$$R_W = \left\{ \left( \frac{1}{\rho_W} D_{WF6} \frac{N'_{WF6}}{\delta} \right)^{-1} + \left( k_0 \exp\frac{-Ea}{kT} \cdot P_{H2}^{1/2} \right)^{-1} \right\}^{-1}$$

dabei ist

| | |
|---|---|
| $\rho$ | die Dichte im Medium |
| $m_i$ | der Massenbruchteil eines Teilchens 1 |
| $t$ | die Zeit |
| $\bar{v}$ | die Geschwindigkeit |
| $D_{ij}$ | der Koeffizient für Multikomponentendiffusion |
| $D_i^T$ | der Koeffizient für Thermodiffusion |
| $T$ | die Temperatur |
| $G_i$ | die Generationsrate des Teilchens i |
| $j_{WF_x}$ | der Fluß von $WF_x$ |
| $k_1$ | $10^{-5}$ kg/(ms) |
| $\theta$ | der Anteil der Fläche, der mit Wolfram bedeckt ist |
| $k_2$ | $10^{-3}$ kg/(ms) |
| $n$ | die Nukleationsrate pro Flächeneinheit |
| $k_3$ | $10^{13}$ s$^{-1}$ m$^{-2}$ |
| $R_w$ | die Abscheiderate von Wolfram |
| $\rho_w$ | Dichte des CVD-Wolframs |
| $D_{WF_6}$ | Diffusionskoeffizient von $WF_6$ in $H_2$ bei den Betriebsbedingungen |

| $N'_{WF_6}$ | die Konzentration von $WF_6$am betrachteten Ort |
|---|---|
| $\delta$ | der Abstand des Ortes von der Siliziumoberfläche |
| $P_{H_2}$ | der Druck des $H^2$ |
| $k_0$ | $4.08 \times 10^6 (nm\ min^{-1}\ pa^{-1/2})$ |
| $E_a$ | die Aktivierungsenergie |
| $[WF_6]$ | Massenbruchteil des Teilchens $WF_6$ |
| $[WF_x]$ | Massenbruchteil des Teilchens $WF_x$ |

2. Verfahren nach Anspruch 1,
bei dem die Bestimmung der Prozeßparameter mit Hilfe von an die Symmetrie des CVD-Reaktors angepaßten Koordinaten erfolgt.

3. Verfahren nach Anspruch 1 oder 2,
bei dem das Gleichungssystem nur in einer Ebene senkrecht zur Siliziumoberfläche gelöst wird.

4. Verfahren nach einem der Ansprüche 1 bis 3,
bei dem die maskierende Struktur aus $SiO_2$ besteht.

## Claims

1. Method for the selective deposition of tungsten on a silicon surface, involving the following steps:
   a) the silicon surface is provided with a masking pattern,
   b) in a CVD reactor, the deposition from the gas phase is carried out from a mixture of process gases which contains $H_2$ and $WF_6$, in such a manner that the masking pattern remains essentially free of tungsten,
   c) the process parameters temperature, pressure and flow rates of the process gases for the selective deposition are determined for a predetermined deposition rate by solving the following equations:

$$\frac{\partial \rho m_i}{\partial t} = div\left( pm_i \bar{v} - \rho \sum_j D_{ij} Vm_j - D_i^T \nabla(lnT) \right) + G_i$$

$$JWF_x = k_1 \theta [WF_6] - k_2 [WF_x]$$
$$n = (1 - \theta)k_3 [WF_x]$$

$$\frac{d\theta}{dt} = (1 - \theta)2\pi R_W \int_0^t n(t')(t - t')R_W dt'$$

$$R_W = \left\{ \left( \frac{1}{\rho_W} D_{WF6} \frac{N'_{WF6}}{\delta} \right)^{-1} + \left( k_0 \exp \frac{-Ea}{kT} \cdot P_{H2}^{1/2} \right)^{-1} \right\}^{-1}$$

where

| $\rho$ | is the density in the medium |
|---|---|
| $m_i$ | is the mass fraction of a particle 1 |
| $t$ | is the time |
| $\bar{v}$ | is the velocity |
| $D_{ij}$ | is the coefficient for multi-component diffusion |
| $D_i^T$ | is the coefficient for thermal diffusion |
| $T$ | is the temperature |
| $G_i$ | is the rate of generation of the particle i |
| $JWF_x$ | is the flux of $WF_x$ |

$k_1$ is $10^{-5}$ kg/(ms)

$\theta$ is the proportion of the area covered with tungsten

$k_2$ is $10^{-3}$ kg/(ms)

n is the nucleation rate per unit area

$k_3$ is $10^{13}.s^{-1}.m^{-2}$

$R_w$ is the deposition rate of tungsten

$\rho_w$ is the density of the CVD tungsten

$D_{WF6}$ is the diffusion coefficient of $WF_6$ in $H_2$ under the operating conditions

$N'_{WF6}$ is the concentration of $WF_6$ at the location under consideration

$\delta$ is the distance of the location from the silicone surface

$P_{H2}$ is the pressure of $H_2$

$k_0$ is $4.08 \times 10^6$ (nm.min$^{-1}$.Pa$^{-1/2}$)

$E_a$ is the activation energy

$[WF_6]$ is the mass fraction of the particle $WF_6$

$[WF_x]$ is the mass fraction of the particle $WF_x$

2. Method according to Claim 1, in which the process parameters are determined with the aid of coordinates adapted to the symmetry of the CVD reactor.

3. Method according to Claim 1 or 2, in which the system of equations is only solved in a plane perpen- dicular to the silicon surface.

4. Method according to one of Claims 1 to 3, in which the masking pattern consists of $SiO_2$.

**Revendications**

1. Procédé de dépôt sélectif du tungstène sur une surface de silicium, qui consiste :

a) à munir la surface de silicium d'une structure de réserve,

b) à effectuer dans un réacteur de dépôt chimique en phase vapeur le dépôt en phase gazeuse dans un mélange de gaz de processus contenant $H_2$ et $WF_6$ de manière que la structure de réserve reste sensiblement exempte de tungstène,

c) à déterminer les paramètres opératoires que sont la température et la pression et les débits des gaz de processus pour le dépôt sélectif pour une vitesse de dépôt prescrite en résolvant les équations suivantes :

$$\frac{\partial \rho m_i}{\partial t} = \mathrm{div}\ (pm_i\bar{v} - \rho \sum_j D_{ij}\nabla m_j - D_i^T \nabla(\mathrm{In}\,T)) + G_i$$

$$\mathrm{J}WF_x = K_1\theta[WF_6] - k_2[WF_x]$$

$$n = (1-\theta)k_3[WF_x]$$

$$\frac{d\theta}{dt} = (1-\theta)2\pi R_W \int_0^t n(t')(t-t')R_W dt'$$

$$R_W = \left\{ \left(\frac{1}{\rho_w}D_{WF_6}\frac{N'WF_6}{\delta}\right)^{-1} + \left(k_0 \exp\frac{-Ea}{kT}.P_{H_2}^{1/2}\right)^{-1} \right\}^{-1}$$

dans lesquelles

$\rho$ est la masse volumique du fluide

$m_i$ est la fraction massique d'une particule 1

$t$ est le temps

$\bar{v}$ est la vitesse

$D_{ij}$ est le coefficient de diffusion de constituants multiples

6

$D_i^T$      est le coefficient de thermodiffusion

$T$      est la température

$G_i$      est la vitesse de production de la particule i

$^JWF_x$      est le flux de $WF_x$

$k_1$      est $10^{-5}$ kg/(ms)

$\theta$      est la proportion de la surface recouverte de tungstène

$k_2$      est $10^{-3}$ kg/(ms)

$n$      est la vitesse de nucléation par unité de surface

$k_3$      est $10^{13}$ $s^{-1}$ $m^{-2}$

$R_w$      est la vitesse de dépôt du tungstène

$\rho_w$      est la masse volumique du tungstène déposé en phase vapeur

$^DWF_6$      est le coefficient de diffusion de $WF_6$ dans $H_2$ dans les conditions de fonctionnement

$^{N'}WF_6$      est la concentration de $WF_6$ à l'emplacement considéré

$\delta$      est la distance de l'emplacement à la surface du silicium

$^PH_2$      est la pression de $H_2$

$k_0$      est 4,08 x $10^6$(nm $mn^{-1}$ $Pa^{-1/2}$)

$E_a$      est l'énergie d'activation

$[WF_6]$      est la fraction massique de la particule $WF_6$

$[WF_x]$      est la fraction massique de la particule $WF_x$

2. Procédé suivant la revendication 1, qui consiste à effectuer la détermination des paramètres opératoires à l'aide de coordonnées adaptées à la symétrie du réacteur de dépôt chimique en phase vapeur.

3. Procédé suivant la revendication 1 ou 2, qui consiste à résoudre le système d'équations seulement dans un plan perpendiculaire à la surface de silicium.

4. Procédé suivant l'une des revendications 1 à 3, dans lequel la structure de réserve est en $SiO_2$.